# EUROPÄISCHE PATENTSCHRIFT

(11) **EP 0 472 888 B1**
(45) Veröffentlichungstag und Bekanntmachung des Hinweises auf die Patenterteilung: **24.06.1998**
(21) Anmeldenummer: 91112081.4
(22) Anmeldetag: 19.07.1991
(51) Int. Cl.: H03K 17/96

(54) **Flachtastatur**
Flat keyboard
Clavier plat

(30) Priorität: 29.08.1990 CH 2806/90
(43) Veröffentlichungstag der Anmeldung: 04.03.1992
(73) Patentinhaber: DYNALAB AG, CH-6330 Cham (CH)
(72) Erfinder: Iten, Thomas, CH-6300 Zug (CH)
(74) Vertreter: Blum, Rudolf Emil Ernst

(56) Entgegenhaltungen:
- EP-A- 0 210 386
- FR-A- 2 576 726
- US-A- 4 458 173
- US-A- 4 618 797

## Beschreibung

Die Erfindung betrifft eine Flachtastatur mit zwischen einer Grund- und einer Deckfolie angeordneten, piezoelektrischen Elementen, die bei im wesentlichen wegloser, mechanischer Beanspruchung ein elektrisches Signal erzeugen. Eine solche Tastatur ist beispielsweise aus der EP-A-210 386 zu entnehmen. Dabei ist jeweils zwischen der Grund- und der Deckfolie als weitere Schicht eine starre Abstandshalterfolie vorgesehen, welche Ausnehmungen für die piezoelektrischen Elemente besitzt und deren Dicke im wesentlichen der Dicke dieser Elemente entspricht. Diese starre Abstandshalterfolie hat unter anderem die Funktion, die piezoelektrischen Elemente zu positionieren, die Leiterbahnen auf den Grund- und Deckfolien voneinander zu trennen und das Uebersprechen zwischen benachbarten Tasten zu verhindern. US-A-4 458 173 zeigt ebenfalls eine Anordnung mit einer Grundplatte, einer Abstandsschicht und einer Deckfolie.

Das Anbringen einer solchen Abstandshalterfolie führt jedoch zu zusätzlichen Arbeitsgängen bei der Herstellung der Tastatur. Ferner sind insgesamt drei Folien und Klebschichten erforderlich.

Es stellt sich erfindungsgemäss die Aufgabe, eine Tastatur der eingangs genannten Art so zu verbessern, dass diese Nachteile entfallen.

Die Lösung dieser Aufgabe ergibt sich aus den Merkmalen, wie sie in den Patentansprüchen umschrieben sind.

Damit gelingt es, die Abstandshalterfolie zu eliminieren, ohne dass damit die Funktion der Tastatur beeinträchtigt wird. Die Flachtastatur lässt sich in weniger Arbeitsgängen und in geringerer Dicke herstellen.

Anhand der Zeichnungen werden nachfolgend Ausführungsbeispiele beschrieben, welche die erfindungsgemässen Merkmale und Vorteile illustrieren.

Darin zeigen:
Figur 1 einen Schnitt durch die Deck- und Grundfolie einer ersten Ausführung der Flachtastatur;
Figur 2 die Flachtastatur gemäss Figur 1 mit zusätzlicher Tragplatte;
Figur 3 eine schematische Darstellung einer ersten Herstellungsvariante einer solchen Flachtastatur;
Figur 4 einen Schnitt durch eine weitere Ausführung der Flachtastatur mit zusätzlicher Tragplatte;
Figur 5 einen Schnitt durch eine dritte Ausführung der Flachtastatur mit zusätzlicher Tragplatte;
Figur 6 eine schematische Darstellung einer möglichen Leiterbahn-Anordung;
Figur 7 einen Schnitt durch die Deck- und Grundfolie der ersten Ausführung der Flachtastatur mit einer zusätzlichen, starren Frontplatte;
Figur 8 eine weitere Variante der Flachtastatur mit ausgewölbter Deck- und Grundfolie;
Figur 9 eine Ausführung der Flachtastatur, bei welcher die Deckfolie Ausnehmungen für die piezoelektrischen Elemente besitzt, und
Figur 10 eine zweite Herstellungsvariante der Flachtastatur.

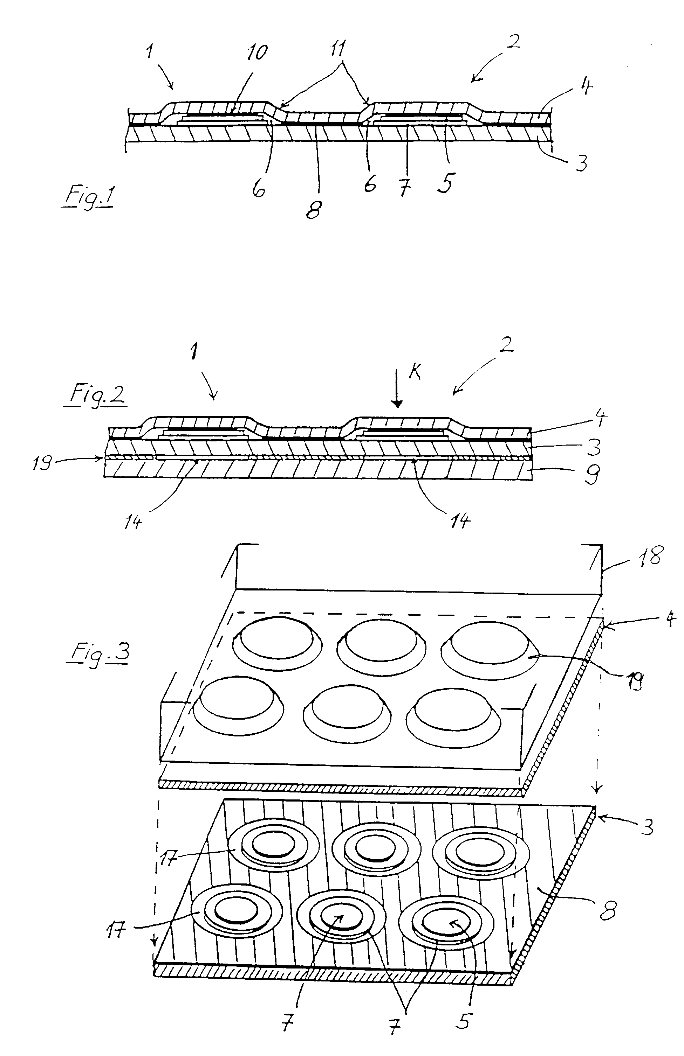

Anhand der Figur 1 soll zunächst der Grundaufbau der Flachtastatur erläutert werden, bevor anhand der weiteren Figuren auf verschiedene Abwandlungen und Ergänzungen hingewiesen wird. Wenn jeweils von Deck- und Grundfolie die Rede ist, schliesst dies nicht aus, dass die Flachtastatur je nach Anwendung auch umgekehrt, d.h. mit der Grundfolie nach der Tastenseite hin, eingesetzt werden kann. Figur 1 zeigt den Schnitt durch zwei benachbarte Tasten 1, 2 der Tastatur. Diese besitzt eine Grundfolie 3 und eine Deckfolie 4, welche zwischen sich die bei jeder Taste 1, 2 angeordneten piezoelektrischen Elemente 5 einschliessen. Dieses sind plättchenförmige Keramik- oder Kristallelemente, 5 zwischen deren Deck- und Grundflächen sich bei mechanischer Belastung eine elektrische Spannung aufbaut. Diese Spannung kann abgegriffen und mittels einer Interface-Elektronik als Betätigungssignal ausgewertet werden, wie an sich bekannt ist. Das piezoelektrische Element 5 ist auf einem scheibenartigen Metall- oder Keramikträger 7 angeordnet, der ihm die nötige mechanische Stabilität verleiht und zugleich als untere Kontaktfläche dient.

An ihrer Oberseite sind die piezoelektrischen Elemente mit einer Anschlussfläche 10 aus leitendem Material versehen. Sowohl die untere Kontaktfläche 7 als auch die obere Anschlussfläche 10 stehen in Kontakt mit Leiterbahnen, die auf den Innenflächen der Folien angeordnet sind, wie noch näher beschrieben wird.

Beim vorliegenden Aufbau kann sowohl die Deckfolie 4 als auch die Grundfolie 3 bei jeder Taste 1, 2 aufgewölbt sein, so dass zwischen Deck- und Grundfolie jeweils eine Kammer 6 für die Aufnahme eines piezoelektrischen Elements gebildet wird. Jede Kammer entspricht in ihrer Ausdehnung im wesentlichen dem darin enthaltenen piezoelektrischen Element 5 auf seinem Träger 7. Im Beispiel von Figur 1 ist die Aufwölbung auf die Deckfolie 4 beschränkt, so dass eine ebene Grundfolie 3 vorhanden ist.

Grund- und Deckfolie 3, 4 sind im übrigen zwischen den Kammern 6 kraftschlüssig miteinander verbunden. Dies kann mittels einer Haftschicht 8 oder durch Laminieren oder Kaschieren der Folien erfolgen. Die Kammern 6 bilden damit eine Art Blasen zwischen den beiden verbundenen Folien 3 4 in denen die piezoelektrischen Elemente 5 und die Träger 7 enthalten sind. Die Betätigung der Tastatur ist dennoch möglich, indem sie praktisch weglos erfolgt, wie noch zu beschreiben ist.

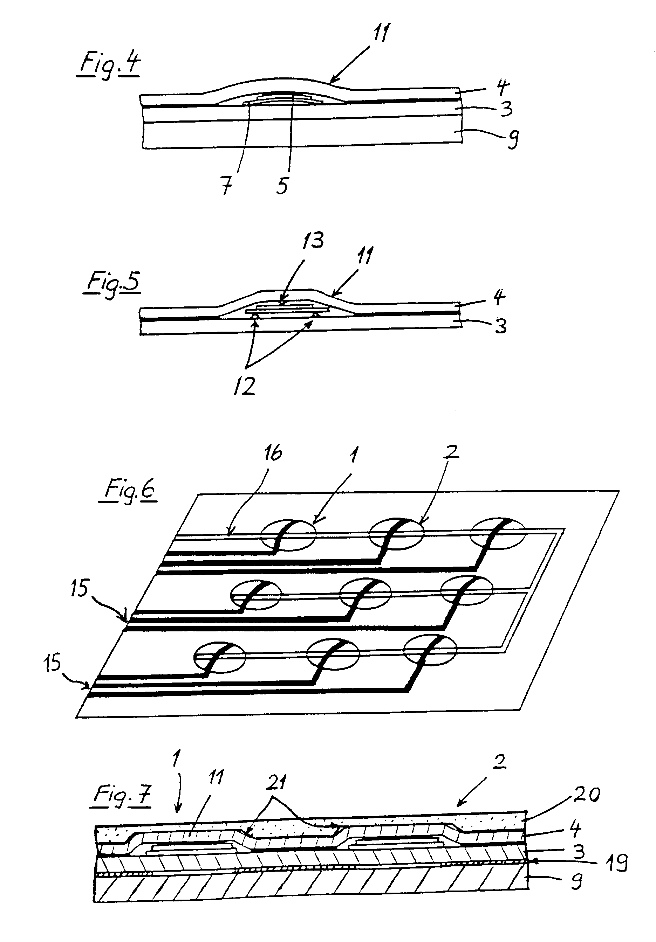

Anhand der Figur 2 soll nun die Funktionsweise näher erläutert werden. Die beschriebene Flachtastatur ist dabei mittels eines Transferklebers 19, welcher im Tastenbereich Löcher 14 bildet, auf einer Tragplatte 9 angeordnet. Der Transferkleber (z.B. vom Typ 3 H, 468) kann eine Dicke von lediglich ca. 1/10 mm aufweisen. Diese Löcher 14 gewährleisten, dass die piezoelektrischen Elemente 5 bei Tastenbetätigung auf Biegung beansprucht werden. Die im Biegemodus ohne merklichen Weg beanspruchten Elemente erzeugen ein Spannungssignal, das als Tastensignal ausgewertet wird. In Figur 2 ist die Betätigungskraft K auf die Deckfolie 4 der einen Taste 2 schematisch gezeigt. Da die Deckfolie 4 im Zwischenbereich zur benachbarten Taste 1 auf der Grundfolie 3 aufliegt und mit ihr kraftschlüssig verbunden ist, wird die Betätigungskraft K in diesem Zwischenbereich vollständig abgebaut, auch wenn die Deckfolie 4 relativ starr ausgebildet ist. Damit findet kein Uebersprechen zwischen benachbarten Tasten 1, 2 statt, auch wenn diese nahe beieinander angeordnet sind.

Da bei der Tastenbetätigung kein merklicher Tastenweg zurückgelegt wird, ist die Beanspruchung der Deckfolie 4 gering.

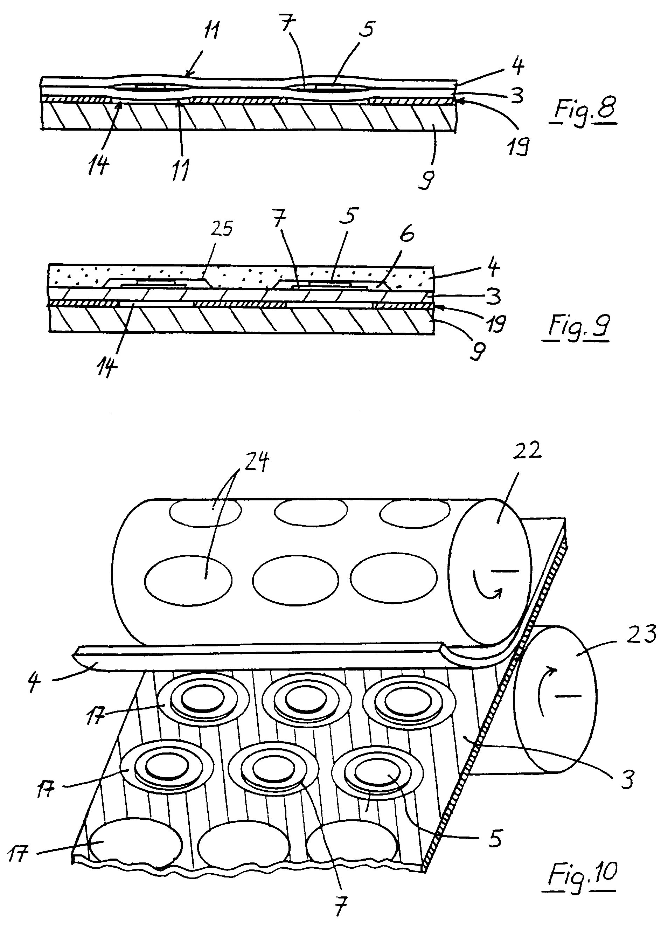

Wie bereits erwähnt, kann die Deckfolie 4 relativ starr ausgebildet sein. In diesem Fall sind die Aufwölbungen 11 in die Deckfolie 4 fest eingeprägt. Wird eine relativ elastische Folie verwendet, so können sich diese durch elastische Verformung derselben bilden, wie in den Beispielen gemäss Figur 4 und Figur 8 gezeigt. In beiden Fällen wird durch eine gerundete, kantenfreie Ausbildung der Aufwölbungen 11 die mechanische Beanspruchung in diesem Bereich herabgesetzt.

In Figur 4 ist ein Ausführungsbeispiel der Erfindung gezeigt, bei welchem das piezoelektrische Element 5 und der Metallträger 7 eine Wölbung besitzen. Der Metallträger 7 liegt nur an seiner Peripherie auf der Grundfolie 3 auf und kann in seinem Zentrum biegeelastisch beansprucht werden. Damit wird das piezoelektrische Element 5 im Biegemodus beansprucht und erzeugt ohne merklichen Weg ein Spannungsignal. Dabei wird also insbesondere die Aufwölbung 11 der Deckfolie 4 nicht merklich eingedrückt. Die Grundfolie 3 ist dabei in der beschriebenen Weise auf eine Tragplatte 9 abgestützt, wobei hier keine Löcher 14 in einer Transferklebschicht notwendig sind. Es ist demzufolge auch möglich, die Grundfolie 3 selbst als starre Tragplatte auszubilden.

Dasselbe gilt für die Ausführung gemäss der Figur 5. Hier wird die Biegebeanspruchung des piezoelektrischen Elements 5 auf dem Träger 7 durch einen an der Deckfolie 4 angeordneten Noppen 13 sowie eine an der Grundfolie 3 angeordnete, ringförmige Auflage 12 bewirkt.

Um bei jedem piezoelektrischen Element 5 die Spannung abgreifen zu können, welche durch die Tastenbetätigung erzeugt wird, sind dessen Kontaktflächen 7, 10 über Leiterbahnen mit einer Interface-Elektronik verbunden. Die Leiterbahnen sind, wie bereits erwähnt, auf den Innenseiten von Grund- und Deckfolie angeordnet und können zum Beispiel mittels eines Druckverfahrens aufgebracht werden.

In Figur 6 ist eine derartige Anordnung in der Grenzfläche zwischen Grund- und Deckfolie dargestellt, wobei die schwarz ausgezogenen Leiterbahnen 15 an der Deckfolie und die als Doppelstrich gezeichneten Leiterbahnen 16, die einen gemeinsamen Massenkontakt bilden, an der Grundfolie angeordnet sind. Wie sich daraus ergibt, schneiden sich die Leiterbahnen 15 an der Deckfolie nur bei den Tasten 1, 2 mit den Leiterbahnen 16 an der Grundfolie, so dass ein Kurzschluss vermieden wird, obschon alle Leiterbahnen in derselben Ebene verlaufen.

An den Kreuzungsstellen werden jeweils die oberen und die unteren Kontaktflächen 7, 10 der piezoelektrischen Elemente kontaktiert.

Anderseits können bei isolierender Haftschicht 8 zwischen den Folien 3, 4 oder bei isolierten Leiterbahnen 16 auch Anordnungen vorgesehen sein, bei denen sich die Leiterbahnen in der Verbindungsebene kreuzen. Die Deck- oder Grundfolie kann dabei auch als Metallfolie ausgebildet sein und den gemeinsamen Massenkontakt 16 für alle piezoelektrischen Elemente bilden, wobei die Metallfolie an ihren restlichen Bereichen mit einer Isolierschicht versehen ist, welche einen Kurzschluss zu den anderen Leiterbahnen 15 verhindert. Die Isolierschicht kann dabei zugleich die Haftschicht 8 zwischen den Folien 3, 4 bilden.

Als Deck- und Grundfolien 3, 4 sind Kunststoff-Folien (oder gegebenenfalls Metallfolien) vorgesehen. Die Grundfolie 3 kann dabei eine Dicke von etwa 0.4 mm und die Deckfolie von 0.1 mm besitzen.

In Figur 3 ist schematisch ein erstes Verfahren dargestellt, um die Folien 3, 4 zur Flachtastatur zu vereinigen. Dieses ist geeignet für relativ starre, plattenartige Anordnungen beschränkter Ausdehnung. Dabei werden zunächst die piezoelektrischen Elemente 5 auf ihren Trägern 7 auf der Grundfolie angeordnet. Hierzu werden Bereiche 17 ausgespart, welche gegebenenfalls nicht mit einem Haftvermittler 8 versehen sind. Die Deckfolie 4 wird hernach mittels eines Stempels 18 (schematisch) gegen die Grundfolie 3 gepresst. Der Stempel 18 weist dabei Ausnehmungen 19 auf, welche den Aufwölbungen 11 entsprechen.

Der Stempel 18 kann beheizt werden, so dass die Deckfolie 4 unter Wärme- und Druckeinwirkung auf die Grundfolie 3 laminiert wird.

Die Deckfolie 4 kann dabei bereits vorgängig mit eingeprägten Aufwölbungen 11 versehen sein oder diese können erst beim Vereinigen von Deck- und Grundfolie erzeugt werden. Wird eine elastische Deckfolie 4 verwendet, so spannt sich diese unter elastischer Dehnung über die piezoelektrischen Elemente (vergleiche zum Beispiel Figur 4), womit sich eine leichte, mechanische Vorspannung ergibt, welche die Anschlusskontaktkräfte günstig beeinflusst.

Wird der in Figur 3 schematisch gezeigte Herstellungsvorgang in einer Inertgasatmosphäre durchgeführt, so bleiben die einzelnen Kammern 6 mit Inertgas gefüllt. Damit lässt sich eine Oxidation der Kontaktflächen langfristig verhindern und damit die Betätigungssicherheit der Tasten sicherstellen.

Figur 10 zeigt schematisch ein zweites Herstellungsverfahren, womit Flachtastaturen im kontinuierlichen Betrieb hergestellt werden können. Die Grund- und Deckfolie 3, 4, welche zuvor mit Leiterbahnen bedruckt wurden, werden dabei fortlaufend zwischen zwei Walzen 22, 23 zusammengefügt, nachdem auf die Grundfolie 3 ein Haftvermittler 8 mit ausgesparten Bereichen 17 aufgebracht worden ist. Dort werden vor dem Zusammenfügen die piezoelektrischen Elemente 5 auf ihren Trägern 7 eingelegt. Die Walzen 22, 23 weisen entsprechende Ausnehmungen 24 auf, womit eine Beaufschlagung und Beschädigung der piezoelektrischen Elemente 5 vermieden wird. Statt einer Verklebung der Schichten kommt auch eine Verschweissung in Frage.

Mit einem solchen Verfahren kann die Flachtastatur in Bandform hergestellt werden. Aus dem Band können hernach einzelne Tastaturen ausgeschnitten werden. Wie in Figur 8 ersichtlich, können dabei sowohl an der Grundfolie wie an der Deckfolie Auswölbungen 11 vorhanden sein. Die unteren Auswölbungen 11 an der Grundfolie 3 werden in den Löchern 14 der Transferklebschicht 19 aufgenommen.

Die beschriebene Tastatur in ihren verschiedenen Ausführungen kann so angeordnet werden, dass die Deckfolie 4 direkt die Oberfläche der Tastatur bildet. Dies ist insbesondere bei der Verwendung von dickeren Deckfolien 4 möglich.

Soll die Tastatur mit einer besonders widerstandsfähigen oder einer im wesentlichen ebenen Oberfläche versehen werden, so wird vor der Deckfolie 4 eine starre Frontplatte 20 angeordnet, wie in Figur 7 gezeigt. Dies kann zum Beispiel eine Metallplatte oder eine Plexiglasplatte von 5 mm Dicke sein, die bei den Tasten 1, 2 Ausnehmungen 21 besitzt, welche die Aufwölbungen 11 aufnehmen. Dort ist die Dicke der Frontplatte auf zum Beispiel ca. 2 mm reduziert, womit eine lokal geschwächte Zone für die Uebertragung des Tastendrucks auf die darunter liegende Struktur entsteht.

Die Frontplatte 20 liegt mit den geschwächten Zonen rückseitig an den Aufwölbungen 11 und mit den ungeschwächten Zonen an den dazwischen liegenden Bereichen der Deckfolie 4 an. Damit wird auch hier ein Uebersprechen zwischen zwei benachbarten Tasten 1, 2 verhindert. Diese Ausgestaltung hat den Vorteil, dass die Tastatur gegen Beschädigungen, insbesondere Vandalenakte, gut geschützt ist und dabei eine nur geringfügig grössere Gesamtdicke aufweist. Anstelle einer Frontplatte 20 kann eine Deckschicht aus einer Vergussmasse, zum Beispiel einem Kunstharz, angeordnet werden, wobei sich die lokal geschwächten Zonen bei den einzelnen Tasten beim Vergiessen von selbst ergeben.

Die Frontplatte kann zugleich auch die Deckfolie 4 bilden, wie dies in der Ausführung gemäss Figur 9 gezeigt ist. Die Kammern 6 für die piezoelektrischen Elemente werden dann von Ausnehmungen 25 an der Unterseite dieser Frontplatte 4 gebildet.

Die beschriebene Flachtastatur hat die verschiedensten Anwendungen. Sie eignet sich insbesondere auch für Anwendungen, bei denen hohe mechanische Beanspruchungen auftreten und mit dem Einwirken von Feuchtigkeit auf die Tastatur zu rechnen ist. Die Ansprechempfindlichkeit der wegfreien Tasten kann durch die Wahl der Folien- beziehungsweise Deckplattendicken und die Interface-Elektronik optimal eingestellt werden.

## Patentansprüche

1. Flachtastatur mit zwischen einer Grund- und einer Deckfolie (3, 4) angeordneten, piezoelektrischen Elementen (5), die bei im wesentlichen wegloser, mechanischer Beanspruchung ein elektrisches Signal erzeugen, dadurch gekennzeichnet, dass die Grund- und Deckfolie (3,4) direkt miteinander verbunden sind und zwischen sich blasenartige Kammern (6) zur Aufnahme jeweils eines piezoelektrischen Elements (5) bilden.

2. Flachtastatur nach Anspruch 1, dadurch gekennzeichnet, dass die Grund- und Deckfolie (3, 4) mindestens um die Kammern (6) herum kraftschlüssig miteinander verbunden sind.

3. Flachtastatur nach einem der vorangehenden Ansprüche, dadurch gekennzeichnet, dass die Grundfolie (3) bzw. die Deckfolie (4) mit Aufwölbungen (11) zur Bildung der Kammern (6) für die piezoelektrischen Elemente (5) versehen ist.

4. Flachtastatur nach Anspruch 3, dadurch gekennzeichnet, dass die Aufwölbungen (11) in die Deckfolie (4) eingeprägt sind.

5. Flachtastatur nach einem der vorangehenden Ansprüche, dadurch gekennzeichnet, dass jedes der piezoelektrischen Elemente (5) auf einer starren Trägerscheibe (7) befestigt ist, über welche es an seiner Unterseite kontaktiert ist, und dass jedes piezoelektrische Element (5) an seiner Oberseite mit einer Anschlussfläche (10) aus leitendem Material versehen ist.

6. Flachtastatur nach einem der vorangehenden Ansprüche, dadurch gekennzeichnet, dass jedes piezoelektrische Element derart gelagert ist, dass es bei Tastenbetätigung auf Biegung beansprucht wird.

7. Flachtastatur nach Anspruch 6, dadurch gekennzeichnet, dass die Grundfolie (3) mittels einer Transferklebschicht (19) auf einer tragenden Platte (9) angeordnet ist, wobei die Transferklebschicht (19) bei den Tasten (1, 2) Oeffnungen (14) bildet, um eine Randabstützung der piezoelektrischen Elemente (5) zu gewährleisten.

8. Flachtastatur nach einem der Ansprüche 1 bis 6, dadurch gekennzeichnet, dass die Deck- oder die Grundfolie eine Metallfolie ist, wobei die beiden Folien über eine Isolierschicht (8) miteinander verbunden sind.

9. Flachtastatur nach einem der vorangehenden Ansprüche, dadurch gekennzeichnet, dass die Deckfolie (4) als im wesentlichen starre Platte ausgebildet ist, oder dass frontseitig eine zusätzliche, im wesentlichen starre Frontplatte (20) angeordnet ist, welche eine ebene Vorderseite besitzt und an ihrer Rückseite Ausnehmungen (21) für die Aufwölbungen der Deckfolie aufweist, so dass sie sich überall auf der Deckfolie abstützt.

10. Flachtastatur nach einem der vorangehenden Ansprüche, dadurch gekennzeichnet, dass die Grundfolie (3) als tragende Platte ausgebildet ist oder auf einer zusätzlichen Tragplatte (9) aufliegt.

## Claims

1. Flat keyboard with piezoelectrical elements (5) placed between a base foil and a cover foil (3, 4), which elements generate an electrical signal when subjected to a mechanical constraint that entails essentially no displacement, characterized in that the base foil and the cover foil (3, 4) are directly joined and that they form between them bubble-like pockets (6) for enclosing one piezoelectrical element (5) each.

2. Flat keyboard according to claim 1, characterized in that the base foil and the cover foil (3, 4) are force-locked together, at least around the pockets (6).

3. Flat keyboard according to one of the preceding claims, characterized in that the base foil (3) and/or the cover foil (4) are provided with bosses (11) in order to form the pockets (6) for the piezoelectrical elements (5).

4. Flat keyboard according to claim 3, characterized in that the bosses (11) are embossed in the cover foil (4).

5. Flat keyboard according to one of the preceding claims, characterized in that each piezoelectrical element (5) is attached on a rigid base plate (7) through which it is contacted at its underside, and that each piezoelectrical element (5) is provided with an electrically conducting contact surface (10) on its upper side.

6. Flat keyboard according to one of the preceding claims, characterized in that each piezoelectrical element is supported so as to be subjected to a bending force when the key is hit.

7. Flat keyboard according to claim 6, characterized in that the base foil (3) is fixed on a carrier plate (9) by a layer (19) of transfer adhesive which has apertures (14) at the positions of the keys (1, 2) in order to support the rim of the piezoelectrical elements (5).

8. Flat keyboard according to one of claims 1 to 6, characterized in that the cover or the base foil is a metallic foil, both foils being joined through an insulating layer (8).

9. Flat keyboard according to one of the preceding claims, characterized in that the cover foil (4) consists in an essentially rigid plate, or that there is provided an additional, essentially rigid front plate (20), which has a plane front face and possesses on its rear face cavities (21) for the bosses of the cover foil, so that it rests everywhere on said cover foil.

10. Flat keyboard according to one of the preceding claims, characterized in that the base foil (3) forms a support plate or rests on an additional support plate (9).

## Revendications

1. Clavier plat, avec des éléments piézo-électriques (5) disposés entre une feuille inférieure et une feuille de couverture (3, 4) et produisant un signal électrique lorsqu'ils subissent un effort mécanique essentiellement dépourvu de déplacement, caractérisé en ce que les feuilles inférieure et de couverture (3, 4) sont réunies directement et forment entre elles des compartiments (6) en forme de bulles pour contenir un élément piézo-électrique (5) chacune.

2. Clavier plat selon la revendication 1, caractérisé en ce que les feuilles inférieure et de couverture (3, 4) sont réunies à force au moins autour des compartiments (6).

3. Clavier plat selon une des revendications précédentes, caractérisé en ce que la feuille inférieure (3), respectivement la feuille de couverture (4), comporte des renflements (11) pour la formation des compartiments (6) recevant les éléments piézo-électriques (5).

4. Clavier plat selon la revendication 3, caractérisé en ce que les renflements (11) sont imprimés dans la feuille de couverture (4).

5. Clavier plat selon une des revendications précédentes, caractérisé en ce que chaque élément piézo-électrique (5) est fixé sur une plaque-support rigide (7) avec laquelle il fait contact à sa surface inférieure, et en ce que chaque élément piézo-électrique (5) comporte à sa face supérieure une surface de connection électrique (10) en un matériau conducteur.

6. Clavier plat selon une des revendications précédentes, caractérisé en ce que chaque élément piézo-électrique est supporté de façon à être sollicité à la flexion lors de l'actionnement de la touche.

7. Clavier plat selon la revendication 6, caractérisé en ce que la feuille inférieure (3) est agencée sur une plaque-support (9) au moyen d'une couche de colle transférable (19) comportant des lucarnes (14) à l'emplacement des touches (1, 2), afin d'assurer un support au bords des éléments piézo-électriques (5).

8. Clavier plat selon une des revendications 1 à 6, caractérisé en ce que la feuille de couverture ou la feuille inférieure est une feuille métallique, les deux feuilles étant réunies par l'intermédiaire d'une couche isolante (8).

9. Clavier plat selon une des revendications précédentes, caractérisé en ce que la feuille de couverture (4) est formée par une plaque essentiellement rigide ou qu'une plaque essentiellement rigide (20) est disposée du côté frontal, cette plaque ayant une face antérieure plane et présentant sur son côté postérieur des évidements (21) pour les renflements de la feuille de couverture de manière à reposer partout sur cette dernière.

10. Clavier plat selon une des revendications précédentes, caractérisé en ce que la feuille inférieure (3) est réalisée sous forme d'une plaque porteuse ou qu'elle repose sur une plaque porteuse additionnelle (9).
